# EUROPEAN PATENT APPLICATION

(11) **EP 4 145 539 A1**
(43) Date of publication of application: **08.03.2023**
(21) Application number: 20933741.9
(22) Date of filing: 21.12.2020
(51) Int. Cl.: H01L 31/024

(54) **COOLING PLATE FOR SOLAR PANEL, AND METHOD FOR MANUFACTURING SAME**

(30) Priority: 29.04.2020 KR 20200052113; 18.12.2020 KR 20200178828
(71) Applicant: Jang Han Engineers, Inc., Dangjin-si, Chungcheongnam-do 31721 (KR)
(72) Inventor: RYU, Kyung Ho, Anyang-si, Gyeonggi-do 13973 (KR); RYU, Won Dae, Seoul 06663 (KR); KIM, Bong Gyu, Hwaseong-si, Gyeonggi-do 18482 (KR)
(74) Representative: Zimmermann, Tankred Klaus
(86) International application number: PCT/KR2020/018783
(87) International publication number: WO 2021/221265

(57) **Abstract**

According to one embodiment, a cooling plate for a solar panel for cooling a solar panel comprises: a planar body positioned on the rear surface of a solar panel; and a fluid guide part comprising a plurality of flow paths for guiding a fluid for cooling the solar panel, between inlets formed on one side of the planar body and outlets formed on the other side of the planar body, wherein the surface of the planar body that comes into direct contact with a back sheet of the solar panel may be flat.

## Description

### TECHNICAL FIELD

It should be evident that the present patent application is a result of government R&D (Project No.: 1545022193) of the Ministry of Agriculture, Food and Rural Affairs of the Republic of Korea. The following description relates to a cooling plate for a solar panel, and a method for manufacturing the same.

### BACKGROUND ART

Photovoltaic power generation generates electricity on a solar panel where p-n bonding is made by performing n-type doping on a silicon crystal, using a photovoltaic effect caused by light energy. To this end, a solar cell for concentrating sunlight, a photovoltaic module that is an assembly of solar cells, and a solar array where solar cells are uniformly arranged are required. In the case of a polycrystalline silicon material that is currently mainstream, the efficiency of a photovoltaic module used for a photovoltaic system is in a range of about 16 to 18%, and is the most important factor for determining the economic feasibility of photovoltaic power generation. In order to continuously improve such power generation efficiency, maintenance and repair through various devices are essential.

Solar cells for concentrating sunlight, solar modules, and solar arrays cause an output decrease of about 0.5% when the temperature rises by 1°C due to a rise in temperature due to sunlight concentration, resulting in reduced power generation efficiency. It is reported that the power generation efficiency decreases by 20 to 30% compared to the maximum because the photovoltaic module is overheated due to a large amount of insolation in summer while an amount of power generated is at its maximum in spring and autumn rather than summer when an amount of sunlight concentrated is at its maximum.

The above-described background technology is possessed or acquired by the inventor in a derivation process of the present invention, and is not necessarily a known technology disclosed to the general public prior to filing of the present application.

### DISCLOSURE OF THE INVENTION

### Technical Goals

An aspect provides a cooling plate for a solar panel that has high cooling efficiency and is easy to manufacture, and a method for manufacturing the cooling plate.

### Technical Solutions

According to an aspect, there is provided a cooling plate for a solar panel for cooling a solar panel, the cooling plate including a planar body positioned on a rear surface of the solar panel, and a fluid guide part including a plurality of flow paths for guiding a fluid for cooling the solar panel, between an inlet formed on one side of the planar body and an outlet formed on the other side of the planar body. A surface of the planar body that comes into direct contact with a back sheet of the solar panel may be flat.

The planar body may include (i) a plurality of bonding parts capable of being bonded to a counterpart by having a flat shape, and (ii) a flow path sheet having a part that is formed to protrude in an opposite direction with respect to the back sheet of the solar panel so as to provide a space through which the fluid flows, and accordingly functions as a plurality of flow paths.

The plurality of bonding parts may be directly bonded to the back sheet of the solar panel, and accordingly the plurality of flow paths may be covered by the back sheet of the solar panel.

The planar body may further include a cover sheet having one surface bonded to the back sheet of the solar panel, and the other surface bonded to the plurality of bonding parts, the cover sheet configured to cover the plurality of flow paths.

A cross section of the flow path sheet cut in a direction perpendicular to a longitudinal direction of the plurality of flow paths may include a curved shape.

In the planar body, a width of a widest part of one of the plurality of flow paths may be greater than 1.2 times and less than 2 times a width of a bonding part formed between the plurality of flow paths.

The cooling plate may further include an insulating sheet disposed to cover the flow path sheet, the insulating sheet configured to prevent heat transfer by forming an air layer between the flow path sheet.

The insulating sheet may include a plurality of first parts configured to surround two or more flow paths among the plurality of flow paths, and a plurality of second parts positioned between the plurality of first parts, the plurality of second parts fixed to an outer surface of the planar body positioned between the plurality of flow paths.

The cooling plate may further include a plurality of cavities formed by perforating a part of the planar body where the plurality of fluid guide parts are not positioned, the plurality of cavities formed to allow a junction box to protrude through the planar body.

The fluid guide part may further include a distribution pipe formed in a part of the fluid guide part connected to the inlet or the outlet, the distribution pipe formed perpendicular to a longitudinal direction of the plurality of flow paths on the planar body.

The distribution pipe may include a plurality of sub-distribution pipes formed in a direction perpendicular to the longitudinal direction of the plurality of flow paths, a connection part configured to interconnect ends of the plurality of sub-distribution pipes in the longitudinal direction of the plurality of flow paths, and a plurality of branch parts configured to branch from a sub-distribution pipe close to the plurality of flow paths among the plurality of sub-distribution pipes toward the plurality of flow paths.

A flow cross-sectional area of a first sub-distribution pipe directly connected to the inlet or the outlet among the plurality of sub-distribution pipes may be greater than a flow cross-sectional area of a second sub-distribution pipe directly connected to the plurality of branch parts.

According to another aspect, there is provided a method for manufacturing a cooling plate for a solar panel including a planar body having (i) a plurality of bonding parts capable of being bonded to a counterpart by having a flat shape, and (ii) a flow path sheet having a plurality of flow paths that are formed to protrude in one direction so as to provide a space through which a fluid flows, the method including forming a mold, placing a first sheet base on the mold and heating the first sheet base, and molding the first sheet base into a shape of the flow path sheet having the bonding part and the plurality of flow paths, using a vacuum molding scheme.

The method may further include attaching a second sheet base having a flat shape to a bonding part of the first sheet base.

### EFFECTS

According to a cooling plate for a solar panel according to an aspect, an effective contact area for heat exchange with respect to a solar panel may be increased compared to a conventional cooling structure, thereby significantly improving cooling efficiency.

According to the cooling plate for a solar panel according to an aspect, a cross section of a flow path through which a cooling fluid flows may have a curved shape (example: a part of a circle), and thus the rigidity of the cooling fluid with respect to hydraulic pressure may be increased, thereby providing a cooling plate for a solar panel having high durability.

According to a method for manufacturing a cooling plate for a solar panel according to another aspect, the ease of manufacturing may be significantly improved compared to a conventional cooling structure formed by bonding a plurality of pipes, using a molding scheme utilizing vacuum.

According to the cooling plate for the solar panel according to an aspect, a bypass flow path may be included in parts through which a cooling fluid is respectively introduced and discharged, thereby improving the flow uniformity of the cooling fluid with respect to the cooling plate for a solar panel.

### BRIEF DESCRIPTION OF DRAWINGS

FIG. 1 is a plan diagram of a cooling plate for a solar panel according to an example embodiment.
FIG. 2 is an enlarged perspective diagram of a part of an inlet side of a cooling plate for a solar panel according to an example embodiment.
FIG. 3 is an enlarged diagram of a part of an inlet side of a cooling plate for a solar panel according to an example embodiment.
FIG. 4 is an enlarged perspective diagram of a part of a central side of a cooling plate for a solar panel according to an example embodiment.
FIG. 5 is a diagram illustrating a flow path and a bonding part according to an example embodiment.
FIG. 6 is a cross-sectional diagram taken along line A-A of FIG. 1.
FIG. 7 is a flowchart illustrating a method of manufacturing a cooling plate for a solar panel according to an example embodiment.
FIG. 8 is a diagram illustrating a photovoltaic module to which a cooling plate for a solar panel according to an example embodiment is applied.
FIG. 9 is a diagram illustrating a photovoltaic module to which a cooling plate for a solar panel according to an example embodiment is applied.
FIG. 10 is a diagram illustrating a photovoltaic module to which a cooling plate for a solar panel according to an example embodiment is applied.

### BEST MODE FOR CARRYING OUT THE INVENTION

Hereinafter, example embodiments will be described in detail with reference to the illustrative drawings. Regarding reference numerals assigned to components in each drawing, it should be noted that the same components will be designated by the same reference numerals, wherever possible, even though they are illustrated in different drawings. In addition, in the description of the example embodiments, detailed description of well-known related configurations or functions will be omitted when it is deemed that such description interferes with the understanding of the example embodiments.

In addition, terms such as first, second, A, B, (a), (b), and the like may be used herein to describe components of the example embodiments. These terms are only used to distinguish one component from another component, and essential, order, or sequence of corresponding components are not limited by these terms. It will be understood that when one component is referred to as being "connected to", "coupled to", or "linked to" another component, one component may be "connected to", "coupled to", or "linked to" another component via a further component although one component may be directly connected to or directly linked to another component.

A component included in any one example embodiment and another component including a function in common with that of the component will be described using the same designation in other example embodiments. Unless otherwise indicated, a description of one example embodiment may be applied to other example embodiments, and a detailed description will be omitted in an overlapping range.

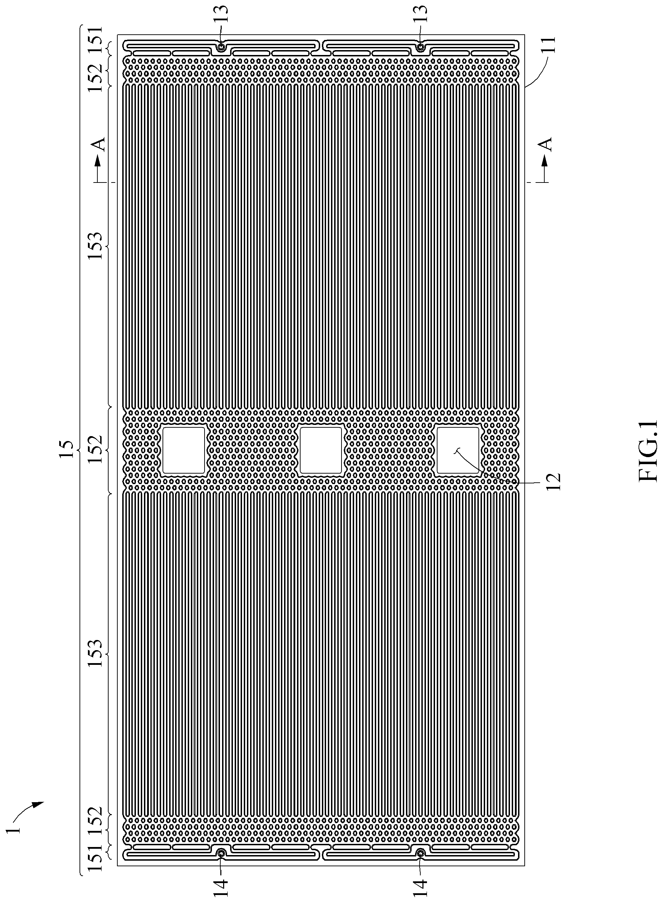

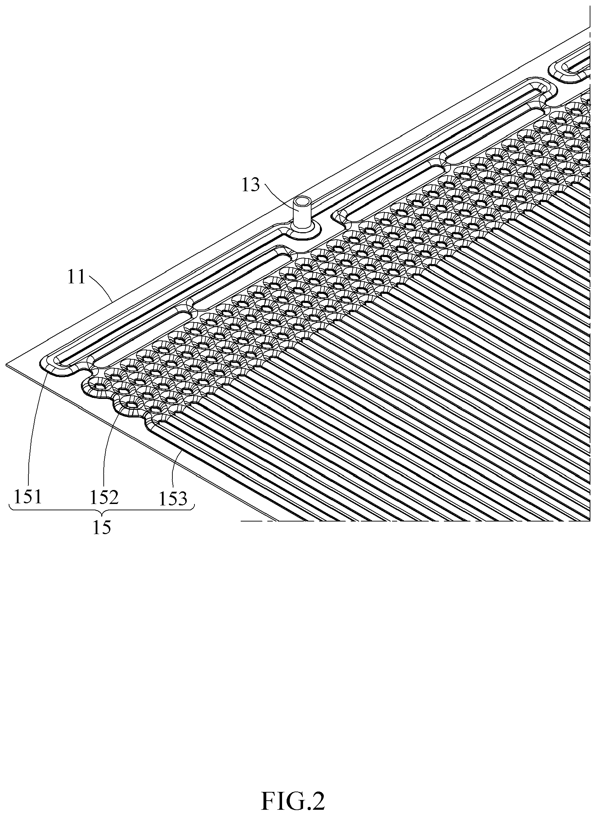

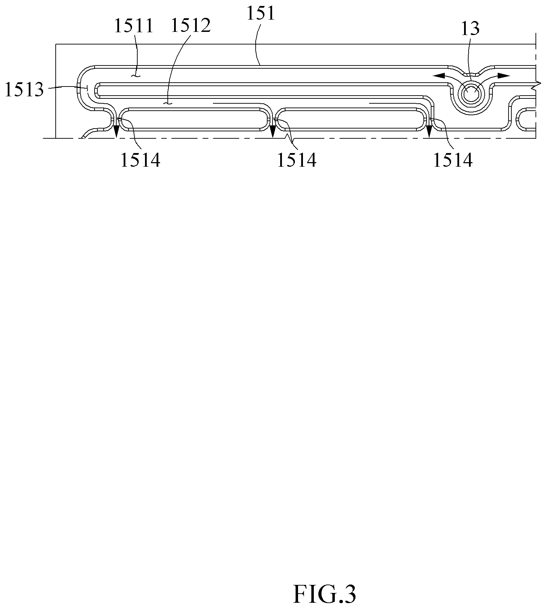

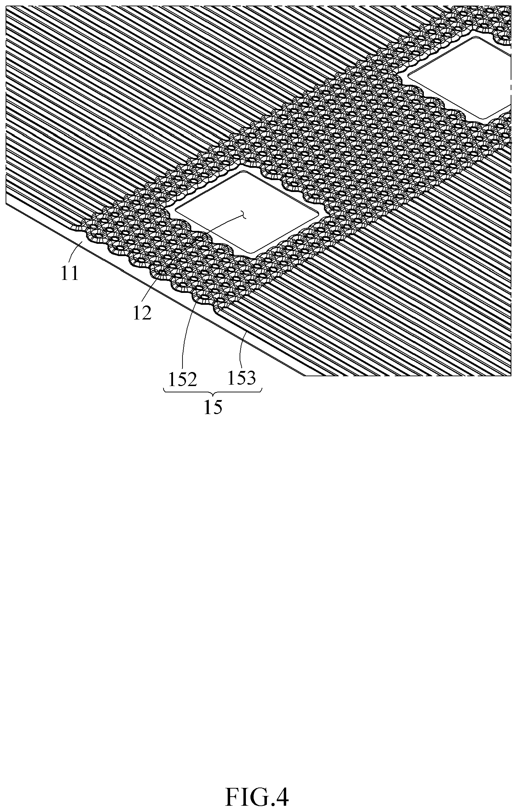

FIG. 1 is a plan diagram of a cooling plate for a solar panel according to an example embodiment. FIG. 2 is an enlarged perspective diagram of a part of an inlet side of a cooling plate for a solar panel according to an example embodiment. FIG. 3 is an enlarged diagram of a part of an inlet side of a cooling plate for a solar panel according to an example embodiment. FIG. 4 is an enlarged perspective diagram of a part of a central side of a cooling plate for a solar panel according to an example embodiment.

Referring to FIGS. 1 to 4, a cooling plate for a solar panel 1 for cooling a solar panel (hereinafter referred to as "cooling plate 1") may be disposed on a rear surface of the solar panel to absorb the heat generated by the solar panel, thereby cooling the solar panel. According to the cooling plate 1 according to an example embodiment, an effective contact area for heat exchange may be increased compared to a conventional cooling structure, thereby significantly improving cooling efficiency. The cooling plate 1 may include a planar body 11, a plurality of cavities 12, an inlet 13, an outlet 14, and a fluid guide part 15.

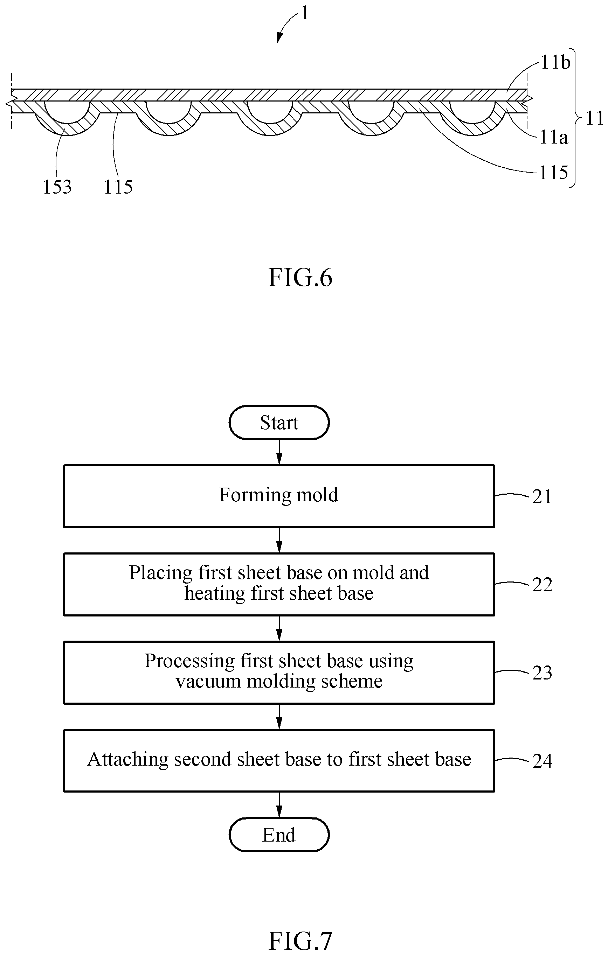

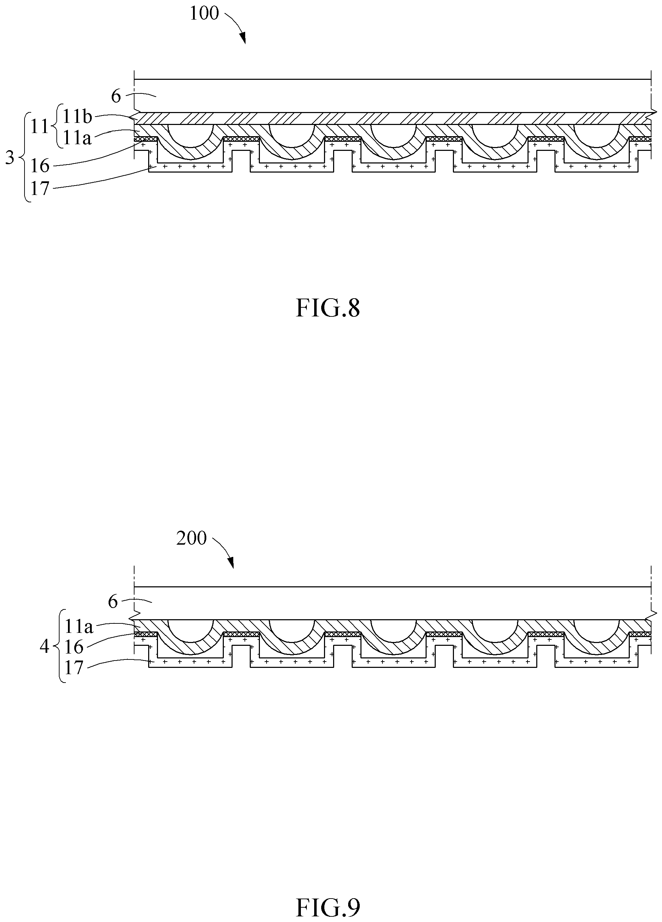

The planar body 11 may be positioned on the rear surface of the solar panel, and may be formed, for example, by coupling a pair of layers (see FIG. 8). In this case, among opposite surfaces of the planar body 11, a surface (a rear surface based on FIG. 1 and an upper surface based on FIG. 6) that comes into direct contact with the solar panel may be flat. According to such a structure, when compared to a cooling structure formed by laterally bonding a general cylindrical pipe, an area where the solar panel and a fluid come into contact with each other by way of the one surface of the planar body 11 may be formed widely.

Alternatively, the planar body 11 may be formed as a single layer (see FIG. 9). In this case, the planar body 11 may be understood as having the same structure as a flow path sheet 11a to be described later. In this case, the flow path sheet 11a may be directly bonded to one side (example: a back sheet) of the solar panel 6 without a cover sheet 11b to be described later. It may be understood that the back sheet of the solar panel 6 is the cover sheet 11b.

Hereinafter, a case in which the planar body 11 is formed by coupling a pair of layers 11a and 11b will be exemplarily described. However, as described above, the planar body 11 may be formed as a single layer 11a, and thus it should be evident that the planar body 11 may be also bonded directly to the back sheet of the solar panel 6.

The plurality of cavities 12 may be formed by perforating a part of the planar body 11 where the plurality of fluid guide parts 15 are not positioned. For example, when the planar body 11 is formed by welding a pair of layers, the plurality of cavities 12 may be formed by perforating a part where the pair of layers are welded. For example, the plurality of cavities 12 may pass through the planar body 11 to allow a junction box to protrude. According to the above-described structure of the cooling plate 1, it may be easily applied to a solar panel to which a half cell technology is applied.

The fluid guide part 15 may include a plurality of flow paths for guiding a fluid for cooling the solar panel, between the inlet 13 formed on one side of the planar body 11 and the outlet 14 formed on the other side of the planar body 11. For example, the fluid guide part 15 may be formed by molding one layer to protrude. The fluid guide part 15 may include a distribution pipe 151, a uniform distribution area 152, and a plurality of flow paths 153.

The distribution pipe 151 may be formed in a part connected to the inlet 13 or the outlet 14 of the fluid guide part 15, and may be formed on the planar body 11 to be long in a direction perpendicular to a longitudinal direction of the plurality of flow paths 153. For example, two distribution pipes 151 may be disposed in parallel on the planar body 11, the two distribution pipes 151 may be connected to be vertically in communication, and one of the distribution pipes 151 may extend in a direction away from the inlet 13 or the outlet 14. The other one of the distribution pipes 151 may distribute the fluid while being closer toward the inlet 13 or the outlet 13. According to such a structure, the fluid may not directly enter the flow path 153 at a speed and pressure introduced through the inlet 13, but may bypass an upper part of the planar body 11 and enter the flow path 153 or the uniform distribution area 152, thereby preventing a phenomenon in which the fluid is intensively injected into the flow path 153 close to the inlet 13 or a bottleneck phenomenon.

Specifically, the distribution pipe 151 may include (i) a plurality of sub-distribution pipes 1511 and 1512 formed in a direction perpendicular to a longitudinal direction of the flow path 153, (ii) a connection part 1513 that interconnects ends of the plurality of sub-distribution pipes 1511 and 1512 in the longitudinal direction of the flow path 153, and (iii) a plurality of branch parts 1514 that branch from the sub-distribution pipe 1512 close to the flow path 153 among the plurality of sub-distribution pipes 1511 and 1512 toward the flow path. For example, as illustrated, a flow cross-sectional area of the first sub-distribution pipe 1511 directly connected to the inlet 13 among the plurality of sub-distribution pipes 1511 and 1512 may be greater than a flow cross-sectional area of the second sub-distribution pipe 1512.

The uniform distribution area 152 may flow fluids flowing toward the plurality of flow paths 153 in a uniformly distributed state while converging or dividing the fluids. For example, the uniform distribution area 152 may be disposed on an inlet side and an outlet side. For example, the uniform distribution area 152 may be disposed in at least one of (i) a part between the inlet 13 and the flow path 153, and (ii) a part between the flow path 153 and the outlet 14. For example, when there is the flow path 153 that bypasses around the cavity 12 among the plurality of flow paths 153, a difference in head loss between fluids passing through respective flow paths 153 may occur. Therefore, when a shape of the fluid guide part 15 is changed according to a path through which the fluid flows, the cooling plate 1 may be uniformly cooled by providing the uniform distribution area 152 to flow the fluid at a uniform flow rate.

For example, the uniform distribution area 152 may include a grid-type branch path as illustrated. For example, the grid-type branch path may be understood as having a structure formed by arranging a plurality of unit adhesive parts having a predetermined shape (example: a circular shape, a rhombus shape, or a hexagonal shape) in a direction perpendicular to a longitudinal direction of the flow path 153. In addition, the arrangement may be made to form a plurality of rows along the longitudinal direction of the flow path 153. At this time, one unit adhesive part included in one row among the plurality of rows may be disposed to be positioned between a pair of unit adhesive parts included in another adjacent row. According to such a structure, the flow uniformity of a fluid may be further improved.

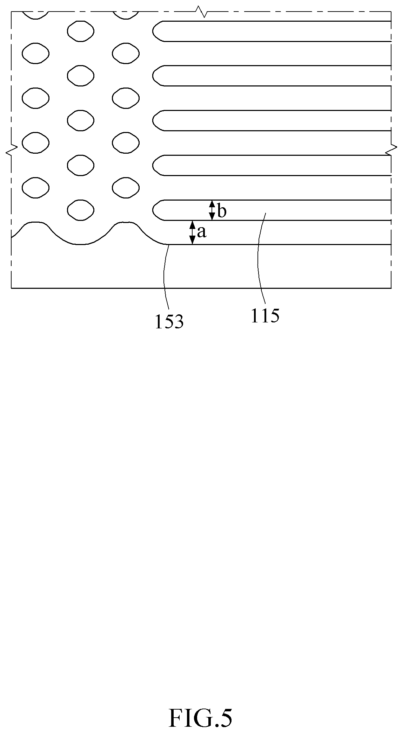

FIG. 5 is a diagram illustrating a flow path and a bonding part according to an example embodiment. FIG. 6 is a cross-sectional diagram taken along line A-A of FIG. 1.

Referring to FIGS. 5 and 6, the planar body 11 may include the cover sheet 11b and the flow path sheet 11a.

The cover sheet 11b, which is one layer constituting the planar body 11, may include a surface that comes into direct contact with a solar panel. The cover sheet 1 1b may have, for example, a shape in which opposite surfaces are generally flat. The cover sheet 1 1b may have one surface bonded to a back sheet of the solar panel and the other surface bonded to a bonding part 115 of the flow path sheet 11a to cover the plurality of flow paths 153.

The flow path sheet 11a, which is another layer constituting the planar body 11, may have a part coupled to the cover sheet 11b and a part not coupled to the cover sheet 11b, and the part not coupled to the cover sheet 11b may be formed to protrude so that the fluid flows.

For example, the flow path sheet 11a and/or the cover sheet 11b may be formed of a polymer material such as polypropylene (PP) or polyethylene (PE), or a metal material to increase a cooling effect by speeding heat transfer. For example, in order to secure high bonding properties, the flow path sheet 11a and the cover sheet 11b may be formed of the same material. For example, the flow path sheet 11a and/or the cover sheet 11b may have a thickness of 1 to 3 mm so as to maximize the cooling effect.

The flow path sheet 11a may have (i) a plurality of bonding parts 115 capable of being bonded to a counterpart by having a flat shape, and (ii) a part that is formed to protrude in an opposite direction with respect to the back sheet of the solar panel so as to provide a space through which the fluid flows, and accordingly functions as the plurality of flow paths 153.

For example, when the planar body 11 is formed of a pair of layers 11a and 11b, the counterpart may be the cover sheet 11b, and the bonding part 115 may be understood as a part bonded to the cover sheet 11b (see FIGS. 6 and 7). As another example, when the planar body 11 is formed of one layer 11a, the counterpart may be the back sheet of the solar panel 6, and the bonding part 115 may be directly bonded to the back sheet of the solar panel 6, and accordingly the plurality of flow paths 153 may be covered by the back sheet of the solar panel 6 (see FIG. 9).

A width a of a widest part of one of the plurality of flow paths 153 may be greater than a width b of the bonding part 115 formed between the plurality of flow paths 153. For example, the width a may be 1.2 times greater than the width b. According to such a structure, a ratio of an area where the bonding parts 115 overlap on the planar body 11 may be decreased, and an area occupied by the flow path 153 through which a cooling fluid flows may be increased. For example, the width a may be less than 2 times the width b. According to such a structure, the area where the bonding parts 115 overlap on the planar body 11 may be sufficiently secured, thereby preventing the flow path sheet 11a and the cover sheet 1 1b from being separated from each other.

As illustrated in FIG. 6, a cross section of the flow path sheet 11a cut perpendicular to a longitudinal direction of the plurality of flow paths 153 may include a curved shape. In other words, a cross section of the flow path 153 may include a curve (example: a semicircle). For example, the flow path sheet 11a may be formed such that a shape that comes into close contact with the bonding part 115 and a semicircle shape that is a cross section of the flow path 153 alternately continue. According to such a structure, not only may the processing of the flow path sheet 11a itself be facilitated through a molding scheme utilizing vacuum, as will be described later, but also a contact area of the flow path 153 that comes into contact with the solar panel may be widened while an area of the bonding part 115 is sufficiently secured. In addition, the durability of the cooling plate 1 may be improved by having high rigidity with respect to a hydraulic pressure of the cooling fluid flowing through the flow path 153.

FIG. 7 is a flowchart illustrating a method of manufacturing a cooling plate for a solar panel according to an example embodiment.

Referring to FIG. 7, a method for manufacturing the cooling plate 1 may include forming a mold (operation 21), placing a first sheet base on the mold and heating the first sheet base (operation 22), processing the first sheet base using a vacuum molding scheme (operation 23), and attaching a second sheet base to the first sheet base (operation 24).

In operation 21, a mold capable of forming a cross section of the flow path sheet into a curved surface may be formed. For example, s shape of the mold may be a wavy shape or a shape in which a flat surface and a curved surface are alternately disposed, according to a shape of a flow path sheet to be manufactured. For example, the mold may have a shape corresponding to the shape of the above-described flow path sheet 11a. The mold may include a plurality of pores formed through a bottom surface of the mold to enable processing using the vacuum molding scheme in operation 22.

Operation 22 may include placing the first sheet base to be formed as the flow path sheet on the mold, and heating the first sheet base. For example, the mold may be heated, and the first sheet base may be placed. The mold may be heated to a temperature at which the first sheet base has ductility required for processing.

Operation 23 may form a vacuum state by discharging air between the mold and the first sheet base through the plurality of pores in the mold. At this time, a space between the mold and the first sheet base may be reduced, and the first sheet base may come into close contact with an inner surface of the mold, thereby forming an outer shape of the mold. Through such a process, the flow path sheet 11a may be formed. For example, the first sheet base may be molded into a shape of the flow path sheet having the above-described bonding part and a plurality of flow paths.

In operation 24, the cooling plate 1 may be completed by attaching a second sheet base (example: the cover sheet 11b) on the formed flow path sheet 11a. For example, the second sheet base may have a shape in which opposite surfaces are flat. At least a part of the second sheet base may be attached to a bonding part of the first sheet base.

For example, in a state in which the first sheet base is molded into the shape of the flow path sheet 11a, operation 24 may include placing the second sheet base to be formed as the cover sheet 1 1b on the first sheet base before separating the first sheet base from the mold, and attaching the second sheet base to the first sheet base. According to such an operation, at a temperature at which the first sheet base has ductility, the second sheet base may be placed on the first sheet base, and accordingly an additional heating process to bond the first sheet base and the second sheet base to each other may be omitted or reduced, thereby reducing costs and efforts required for a processing process.

As another example, operation 24 may include separating the first sheet base molded into the shape of the flow path sheet 11a from the mold, and attaching the second sheet base to be formed as the cover sheet 11b to the first sheet base. At this time, the attaching may include thermal welding and/or high frequency welding. Alternatively, the attaching may include a conventional processing operation of bonding a polymer material or a metal material.

FIG. 8 is a diagram illustrating a photovoltaic module to which a cooling plate for a solar panel according to an example embodiment is applied.

Referring to FIG. 8, the photovoltaic module 100 may include the solar panel 6 and a cooling plate 3 (example: the cooling plate 1 of FIG. 1). The cooling plate 3 may include the planar body 11, a plurality of cavities, an inlet, an outlet, a fixing part 16, and an insulating sheet 17.

The fixing part 16 may fix the insulating sheet 17 to the flow path sheet 11a. The fixing part 16 may include an adhesive material such as an epoxy or an elastic adhesive. Alternatively, a part of the flow path sheet 11a and a part of the insulating sheet 17 may be attached to each other in a welded state. At this time, as a welding method, a thermal welding scheme and/or a high frequency welding scheme may be used.

The insulating sheet 17 may be disposed to cover the flow path sheet 11a, so that an air layer may be formed between the flow path sheet 11a and the heat insulating sheet 17 to prevent heat transfer. When an outdoor temperature is higher than a temperature of the solar panel 30, the insulating sheet 17 may be heated to the outdoor temperature to prevent a phenomenon in which heat transfer is reversed from the fluid to the solar panel 30. For example, the insulating sheet 17 may include asbestos, cork, felt, quartz wool or perlite to block heat transfer from the outside. In addition, the insulating sheet 17 may be formed of a transparent material. According to such a structure, whether there is any damage or a congested section may be easily identified with the naked eye, so maintenance is easy. The insulating sheet 17 by itself may prevent heat exchange with the outside, and may also form an air layer between the insulating sheet 17 and the flow path sheet 11a to prevent heat transfer by the air layer. For example, the insulating sheet 17 may be formed to have a cross section with a concave-convex shape, and the insulating sheet 17 may be fixed to the flow path sheet 11a at intervals to form an air layer around a part of the flow path sheet 11a forming the flow path 153.

FIG. 9 is a diagram illustrating a photovoltaic module to which a cooling plate for a solar panel according to an example embodiment is applied.

Referring to FIG. 9, the photovoltaic module 200 may include the solar panel 6 and a cooling plate 4. The cooling plate 4 may include the flow path sheet 11a, a plurality of cavities, an inlet, an outlet, the fixing part 16, and the insulating sheet 17.

As illustrated, it should be noted that the cooling plate 4 may be manufactured by adhering the flow path sheet 11a directly to the back sheet of the solar panel 6 without a cover sheet.

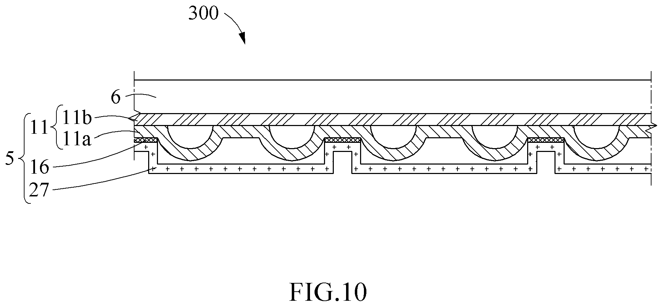

FIG. 10 is a diagram illustrating a photovoltaic module to which a cooling plate for a solar panel according to an example embodiment is applied.

Referring to FIG. 10, the photovoltaic module 300 may include the solar panel 6 and a cooling plate 5. The cooling plate 5 may include the planar body 11, a plurality of cavities, an inlet, an outlet, the fixing part 16, and an insulating sheet 27.

The insulating sheet 27 may have a shape surrounding two or more flow paths (example: 153). According to such a structure, the photovoltaic module 300 may secure more air layers than the example embodiment illustrated in FIG. 8, thereby further improving an insulation effect caused by the air layers. In other words, the insulating sheet 27 may include a plurality of first parts surrounding at least two flow paths among the plurality of flow paths 153, and a plurality of second parts fixed to the bonding part 115 of the planar body 11, and the plurality of first parts and the plurality of second parts may be alternately disposed. In other words, the plurality of second parts may be understood as parts positioned between the plurality of first parts and fixed to an outer surface of the planar body 11 positioned between the plurality of flow paths 153.

A number of example embodiments have been described above. Nevertheless, it should be understood that various modifications may be made to these example embodiments. For example, suitable results may be achieved if the described techniques are performed in a different order and/or if components in a described system, architecture, device, or circuit are combined in a different manner and/or replaced or supplemented by other components or their equivalents.

## Claims

1. A cooling plate for a solar panel for cooling a solar panel, the cooling plate comprising:
a planar body positioned on a rear surface of the solar panel; and
a fluid guide part including a plurality of flow paths for guiding a fluid for cooling the solar panel, between an inlet formed on one side of the planar body and an outlet formed on the other side of the planar body,
wherein a surface of the planar body that comes into direct contact with a back sheet of the solar panel is flat.

2. The cooling plate of claim 1, wherein the planar body comprises:
(i) a plurality of bonding parts capable of being bonded to a counterpart by having a flat shape, and
(ii) a flow path sheet having a part that is formed to protrude in an opposite direction with respect to the back sheet of the solar panel so as to provide a space through which the fluid flows, and accordingly functions as a plurality of flow paths.

3. The cooling planar of claim 2, wherein the plurality of bonding parts are directly bonded to the back sheet of the solar panel, and accordingly the plurality of flow paths are covered by the back sheet of the solar panel.

4. The cooling planar of claim 2, wherein the planar body further comprises:
a cover sheet having one surface bonded to the back sheet of the solar panel, and the other surface bonded to the plurality of bonding parts, the cover sheet configured to cover the plurality of flow paths.

5. The cooling plate of claim 2, wherein a cross section of the flow path sheet cut in a direction perpendicular to a longitudinal direction of the plurality of flow paths includes a curved shape.

6. The cooling plate of claim 2, wherein in the planar body, a width of a widest part of one of the plurality of flow paths is greater than 1.2 times and less than 2 times a width of a bonding part formed between the plurality of flow paths.

7. The cooling plate of claim 2, further comprising:
an insulating sheet disposed to cover the flow path sheet, the insulating sheet configured to prevent heat transfer by forming an air layer between the flow path sheet.

8. The cooling plate of claim 7, wherein the insulating sheet comprises:
a plurality of first parts configured to surround two or more flow paths among the plurality of flow paths; and
a plurality of second parts positioned between the plurality of first parts, the plurality of second parts fixed to an outer surface of the planar body positioned between the plurality of flow paths.

9. The cooling plate of claim 1, further comprising:
a plurality of cavities formed by perforating a part of the planar body where the plurality of fluid guide parts are not positioned, the plurality of cavities formed to allow a junction box to protrude through the planar body.

10. The cooling plate of claim 1, wherein the fluid guide part further comprises:
a distribution pipe formed in a part of the fluid guide part connected to the inlet or the outlet, the distribution pipe formed perpendicular to a longitudinal direction of the plurality of flow paths on the planar body.

11. The cooling plate of claim 10, wherein the distribution pipe comprises:
a plurality of sub-distribution pipes formed in a direction perpendicular to the longitudinal direction of the plurality of flow paths;
a connection part configured to interconnect ends of the plurality of sub-distribution pipes in the longitudinal direction of the plurality of flow paths; and
a plurality of branch parts configured to branch from a sub-distribution pipe close to the plurality of flow paths among the plurality of sub-distribution pipes toward the plurality of flow paths.

12. The cooling plate of claim 11, wherein a flow cross-sectional area of a first sub-distribution pipe directly connected to the inlet or the outlet among the plurality of sub-distribution pipes is greater than a flow cross-sectional area of a second sub-distribution pipe directly connected to the plurality of branch parts.

13. A method for manufacturing a cooling plate for a solar panel comprising a planar body having (i) a plurality of bonding parts capable of being bonded to a counterpart by having a flat shape, and (ii) a flow path sheet having a plurality of flow paths that are formed to protrude in one direction so as to provide a space through which a fluid flows, the method comprising:
forming a mold;
placing a first sheet base on the mold and heating the first sheet base; and
molding the first sheet base into a shape of the flow path sheet having the bonding part and the plurality of flow paths, using a vacuum molding scheme.

14. The method of claim 13, further comprising:
attaching a second sheet base having a flat shape to a bonding part of the first sheet base.
